Europäisches Patentamt

European Patent Office

Office européen des brevets

(11) Publication number: 0 174 020
A2

# EUROPEAN PATENT APPLICATION

(21) Application number: 85111173.2

(22) Date of filing: 04.09.85

(51) Int. Cl.⁴: **H 01 L 23/36**

(30) Priority: 04.09.84 US 646872

(43) Date of publication of application:
12.03.86 Bulletin 86/11

(84) Designated Contracting States:
AT BE DE FR GB IT NL

(71) Applicant: GTE Products Corporation
100 West 10th Street
Wilmington, DE 19801(US)

(72) Inventor: Gilder, Thomas G.
17 Franklin Street
Warren Pennsylvania 16365(US)

(72) Inventor: O'Dean, Raymond D.
3620 Willow Road
Dover, PA 17404(US)

(74) Representative: Patentanwälte Grünecker, Kinkeldey,
Stockmair & Partner
Maximilianstrasse 58
D-8000 München 22(DE)

(54) Integrated circuit package with integral heat dissipating means.

(57) Integral heat dissipating ribs or troughs are formed on
the cover or base or both of integrated circuit packages.
Depending upon the form selected, cover surface area can be
increased by 41% to 57% thereby adding to the convection
capacity of the package.

FIG.1

INTEGRATED CIRCUIT PACKAGE WITH
INTEGRAL HEAT DISSIPATING MEANS

Technical Field

This invention relates to integrated circuit packages and more particularly to such packages having improved heat dissipation.

Background Art

Integrated circuit packages comprise an integrated circuit chip mounted within a housing which usually comprises a support, or base, and a cover. A plurality of lead-ins project from this housing so that electrical connection can be made between an external circuit and the chip. The housing is fabricated from electrically insulating material, usually ceramic or plastic.

In operation, the chip generates heat which is dissipated by the package through conduction and convection. Present attempts to encourage heat dissipation from premolded or post molded packages usually employ heat sinks or additional, external radiators. While workable, these solutions involve extra cost and assembly operations.

Disclosure of Invention

It is, therefore an object of this invention to obviate the disadvantages of the prior art.

It is another object of the invention to enhance the operation of integrated circuit packages.

These objects are accomplished, in one aspect of the invention, by the provision of an integrated circuit package which includes a cover having a reference plane. Integral heat dissipating means are formed with the cover relative to the reference plane. The heat dissipating means provide a greater surface area than the reference plane.

The integral formation of heat dissipating means greatly reduces the cost of the device as well as the weight thereof by eliminating the previously employed metal radiators.

## Brief Description of the Drawings

Fig. 1 is a plan view of an embodiment of the invention;

Fig. 2 is a side elevational view thereof;

Fig. 3 is a plan view of an alternate embodiment of the invention;

Fig. 4 is a side elevational view of the embodiment of Fig. 3;

Fig. 5 is a side elevational view of yet another embodiment;

Fig. 6 is a side elevational view of still another embodiment;

Fig. 7 is a plan view of another embodiment of the invention;

Fig. 8 is a side elevational view of the embodiment of Fig. 7; and

Fig. 9 is a perspective view of a prior art device.

## Best Mode For Carrying Out The Invention

For a better understanding of the present invention, together with other and further objects, advantages and capabilities thereof, reference is made to the following disclosures and appended claims taken in conjunction with the above-described drawings.

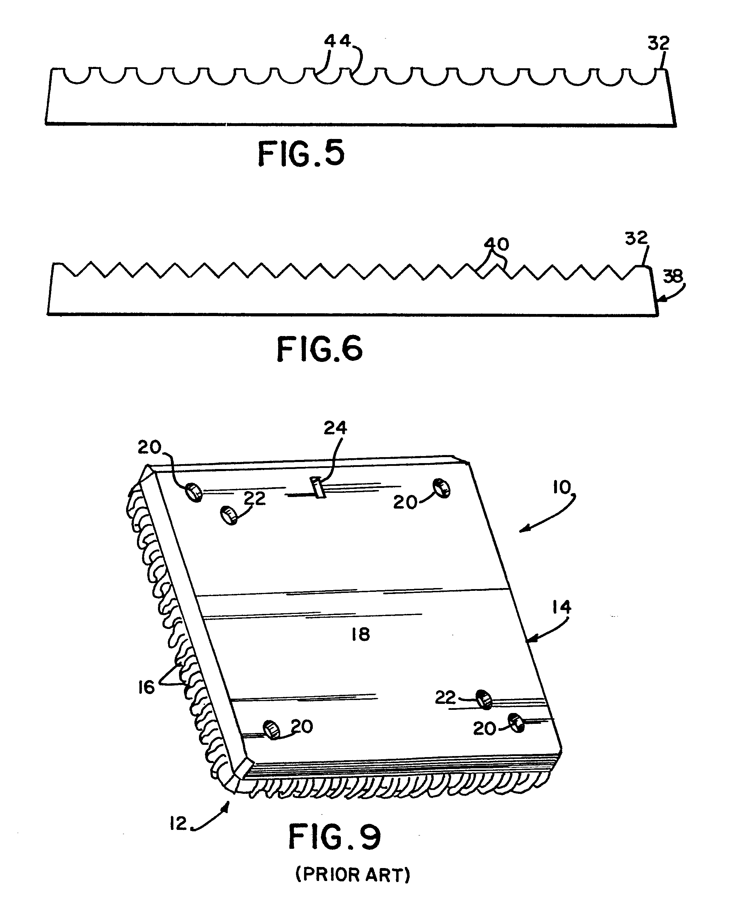

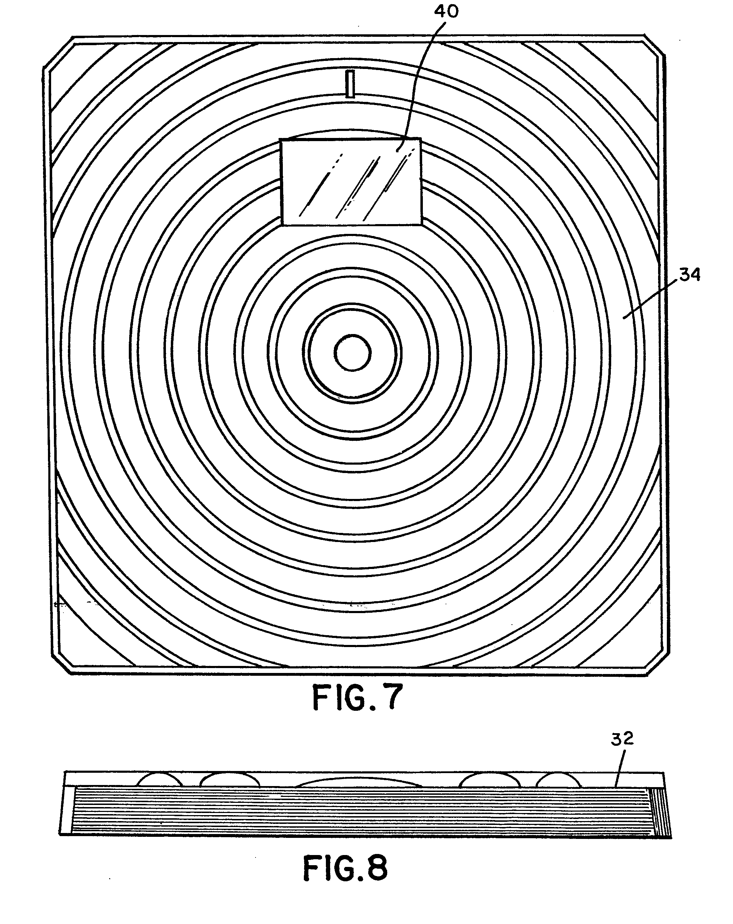

Referring now to the drawings with greater particularly, and briefly to Fig. 9, there is shown a prior art integrated circuit package 10 comprising a support or base 12 and a cover 14. The support and cover define between them a hollow center for enclosing an integrated circuit chip (not shown) to which are attached a plurality of lead-ins 16 which project outside the package 10 for attachment to an external electrical circuit.

The cover 14 has a planar upper surface or reference plane 18 which may have holes 20 therein for mating with alignment studs (not shown) formed on support 11. Additional apertures 22 could be provided for the insertion of a sealing compound for additional protection of the encased chip. A lead-in identifier 24 may also be formed in cover 14.

Integrated circuit packages such as described above are shown in U.S. Serial No. 606,311; filed May 2, 1984 and assigned to the assignee of this application.

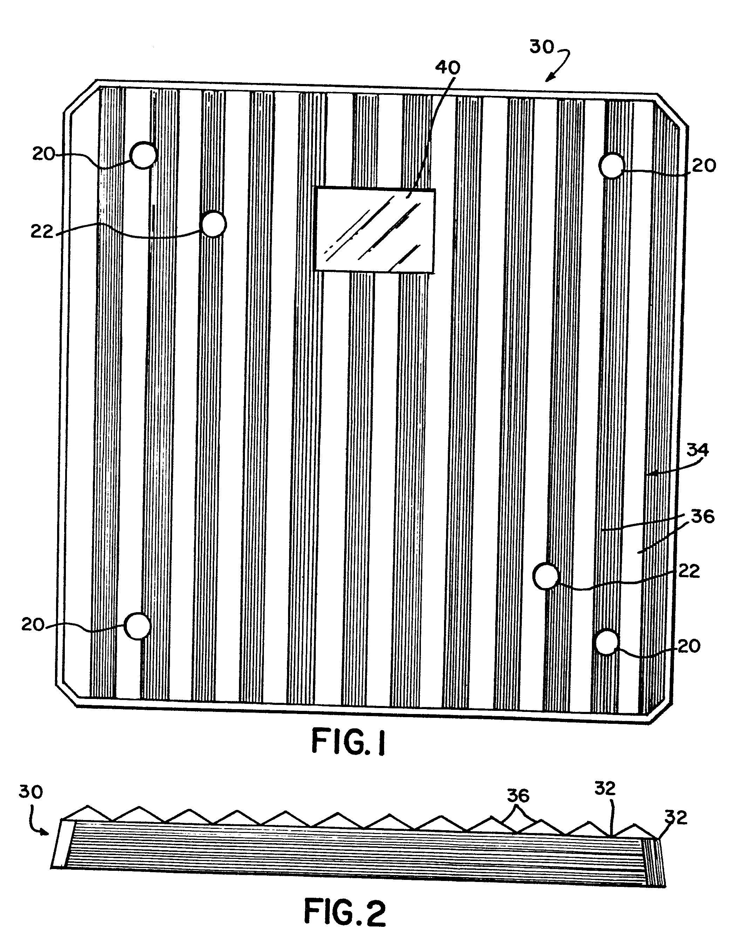

Preferring now to Fig. 1 and Fig. 2, there is shown a cover 30 for an integrated circuit package. Cover 30 has a reference a plane 32 and integral heat dissipating means 34 formed thereon. In the embodiment shown in Figs. 1 and 2 the heat dissipating means 34 comprises a plurality of triangular ribs 36 formed above the reference plane 32; i.e., the thickness of cover 30 is increased by the thickness (altitude) of the triangular ribs. In a preferred form the ribs have an angle of 45° and an altitude of 0.005 inches (0.125mm). Cover 30 may be, e.g., about 0.980 inches ( 24.5mm) square. With complete coverage of reference plane 32, i.e., ribs 36 are contiguous, the surface area of cover 30 is about 41% greater than reference plane 32.

In Fig. 6 is illustrated an alternate embodiment

wherein a cover 38 utilizes triangular ribs 40 formed below reference plane 32. The surface area increase is the same as for cover 30; however, less material is employed.

Cover 30 may also be provided with apertures 20 for securement to a base and apertures 22 for receiving a sealing compound. For clarity, these apertures are not shown in the other embodiments; also, it is to be understood that their inclusion is exemplary only and that other fastening and sealing techniques may be employed.

In a preferred form of the invention a flat space 40 is provided to receive identifying indicia. Further, if flat space 40 is positioned off-center, as shown, it may also function as a lead identifier corresponding to item 24 of Fig. 9.

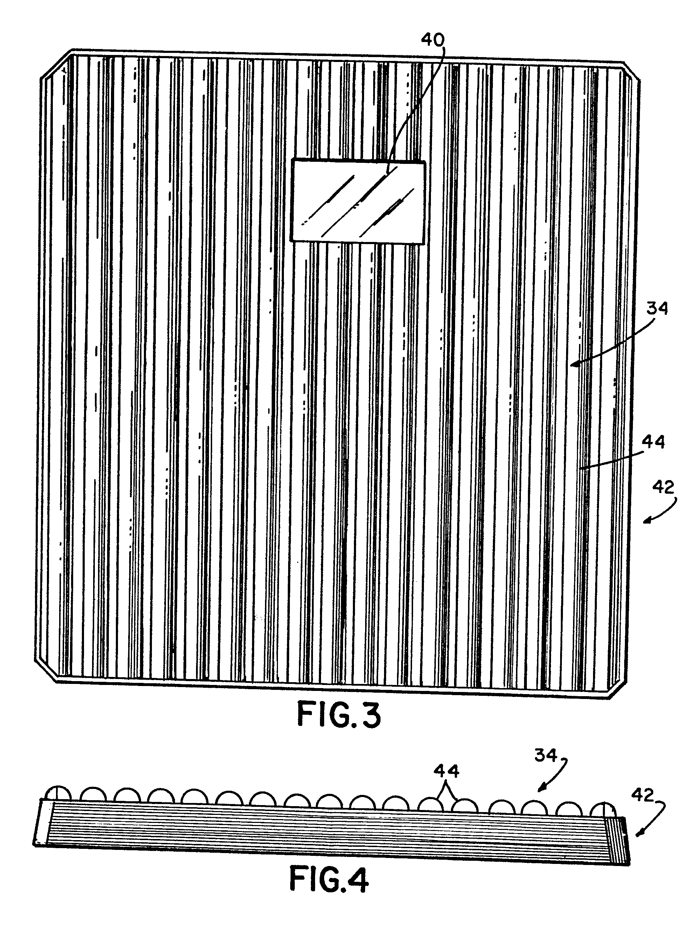

Another alternate embodiment is shown in Figs. 3 and 4 wherein a cover 42 is provided with heat dissipating means 34 in the form of semi-cylindrical ribs 44 extending above reference plane 32. Ribs 42 can have a radius of 0.005 inches (0.125mm) and be separated by about 0.0025 inches (0.0625mm). The converse application is shown in Fig 5 wherein semi-cylindrical troughs 44 are formed below reference plane 32. In the embodiments of Figs. 3 and 5, the surface area increase is about 57% relative to reference plane 32.

Yet another embodiment is shown in Figs. 7 and 8 wherein heat dissipating means 34 are formed in a circular pattern. While semi-cylindrical ribs are indicated it is to be understood that other configurations can be employed; either above or below a reference plane 32.

It is also to be understood that the integral heat dissipating means 34 can be formed in the base as well as the cover. Further, additional surface treatment, such as metal plating or coating may be included.

The heat dissipating means can be provided to already formed parts by machining; however, mold modification is the preferred and least expensive alternative.

Also, while the drawings illustrate the longitudinal ribs or troughs to be perpendicular (relative to the drawings) it is to be understood that they may be horizontal or to have any angle between $0^{\circ}$ and $90^{\circ}$.

While there have been shown and described what are at present considered to be the preferred embodiments of the invention, it will be apparent to those skilled in the art that various changes and modifications can be made herein without departing from the scope of the invention as defined by the appended claims.

Claims

1. An integrated circuit package including a cover having a reference plane, the improvement comprising; integral heat dissipating means formed with said cover relative to said reference plane, said heat dissipating means providing a greater surface area than said reference plane.

2. The integrated circuit package of Claim 1 wherein said greater surface area provides an increase of form about 40% to about 57% relative to said reference plane.

3. The integrated circuit package of Claim 2 wherein said integral heat dissipating means comprise formed protuberances extending above said reference plane.

4. The integrated circuit package of Claim 2 wherein said integral heat dissipating means comprise grooves formed below said reference plane.

5. The integrated circuit package of Claim 3 wherein said formed protuberances are triangular in cross-section.

6. The integrated circuit package of Claim 3 wherein said formed protuberances are semi-cylindrical in cross-section.

7. The integrated circuit package of Claim 4 wherein said grooves are triangular in cross-section.

8. The integrated circuit package of Claim 4 wherein said grooves are semi-cylindrical in cross-section.

0174020

FIG.1

FIG.2

0174020

**FIG.3**

**FIG.4**

0174020

44    32

**FIG.5**

40    32
38

**FIG.6**

24
20    22    20    10
16    18    14
22
20    20
12    **FIG.9**

(PRIOR ART)

FIG. 7

FIG.8